# EUROPÄISCHE PATENTSCHRIFT

(11) **EP 3 424 081 B1**
(45) Veröffentlichungstag und Bekanntmachung des Hinweises auf die Patenterteilung: **29.12.2021**
(21) Anmeldenummer: 17706506.7
(22) Anmeldetag: 22.02.2017
(51) Int. Cl.: H01L 25/075, H01L 33/48, H01L 33/50, H01L 33/52, H01L 33/54, H01L 33/56, H01L 33/58

(54) **CSP LED MODUL MIT VERBESSERTER LICHTEMISSION**
CSP LED MODULE HAVING IMPROVED LIGHT EMISSION
MODULE DE LED CSP À ÉMISSION DE LUMIÈRE AMÉLIORÉE

(30) Priorität: 29.02.2016 DE 102016203162
(43) Veröffentlichungstag der Anmeldung: 09.01.2019
(73) Patentinhaber: Tridonic GmbH & Co. KG, 6850 Dornbirn (AT)
(72) Erfinder: DOBOS, Janos, 9700 Szombathely (HU); RIEMER, Steffen, 8564 Krottendorf-Gaisfeld (AT); SZÜCS, Anna, 8380 Jennersdorf (AT); GRUENDLING, Vladimir, 8280 Fürstenfeld (AT)
(74) Vertreter: Rupp, Christian
(86) Internationale Anmeldenummer: PCT/EP2017/054099
(87) Internationale Veröffentlichungsnummer: WO 2017/148775

(56) Entgegenhaltungen:
- DE-A1-102012 213 343
- DE-A1-102013 109 890
- US-A1- 2006 091 788
- US-A1- 2006 274 524
- US-A1- 2013 056 749
- US-A1- 2013 187 178
- US-A1- 2014 054 616
- US-A1- 2015 008 462

## Beschreibung

### Gebiet der Erfindung

Die vorliegende Erfindung betrifft ein LED Modul mit sogenannten "Chip-Scale Package" LEDs, welche individuell mit einer Farbkonversionsschicht vergossen sind, wobei das LED Modul eine verbesserte Lichtemission aufweist.

### Hintergrund und Aufgabe der Erfindung

Farbkonvertierte LED Chips und LED Module aufweisend einen oder mehrere LED Chips sind aus dem Stand der Technik hinreichend bekannt. Üblicherweise wird ein LED Chip auf einen Träger aufgebracht und anschließend mit einer einen Leuchtstoff aufweisenden Vergussmasse vergossen. Die Vergussmasse kann beispielsweise eine Matrix aus Silikonmaterial sein, in welche Leuchtstoffpartikel eingebracht sind, welche das vom LED Chip emittierte Licht wenigstens teilweise in Licht einer höheren Wellenlänge umwandeln. Das so erhaltene Mischlicht aus beispielsweise blauem Primärlicht der LED und gelbem Sekundärlicht der Leuchtstoffpartikel ermöglicht die Bereitstellung einer Weißlichtquelle.

Derartige LED Module mit mehreren LED Chips können beispielsweise durch ein sogenanntes "Dam-and-fill" Verfahren hergestellt werden, wobei auf einer Oberfläche des Trägers neben den LED Chips ein aus beispielsweise Silikonmaterial geformter Damm aufgebracht wird, welcher die LED Chips umgibt. Die dadurch entstehende Kavität wird anschließend mit Leuchtstoff enthaltender Vergussmasse gefüllt.

Ein weiteres Herstellungsverfahren für ein derartiges LED Modul ist in der US 2013/0063939 A1 beschrieben, wobei zunächst ein mehrere Schichten aufweisendes optisches Element vorgeformt wird, welches Leuchtstoff enthält und welches anschließend auf die bereits auf einem Träger angeordneten LED Chips aufgebracht wird.

Bei der Herstellung dieser konventionellen Weißlicht LED Module werden die einzeln von einem Wafer abgetrennten "nackten" LED Chips bzw. LED Dies also in einem sogenannten Verpackungsschritt (engl: "packaging") in einem Gehäuse eingebracht bzw. auf einen Träger aufgebracht, mit diesem kontaktiert und mit einer Leuchtstoffschicht bedeckt.

Eine jüngere Alternative zu den oben genannten konventionellen Herstellungsverfahren für ein LED Modul ist die Bereitstellung von "Chip Scale Packaging" (CSP) LED Chips, welche dann auf einem Träger angeordnet werden. Derartige CSP LED Chips werden bei der Chip-Herstellung aus einem Wafer mit bereits aufgebrachter Vergussmasse durch das sogenannte "Dicing" herausgetrennt. Die auf den Wafer aufgebrachte Vergussmasse kann bereits einen Leuchtstoff enthalten.

Im Gegensatz zu den konventionellen Herstellungsverfahren, bei dem die einzelnen "nackten" LED Chips bzw. LED Dies aus einem Wafer durch "Dicing" herausgetrennt werden bevor ein individuelles Verpacken, das sogenannte "Packaging", unter Einschließen der LED Chips in Vergussmasse und/oder Leuchtstoff stattfindet, erfolgt bei der Herstellung der CSP LED Chips ein "Packaging" des gesamten Wafers, bevor dieser in einem "Dicing"-Schritt in einzelne, individuell mit Vergussmasse und/oder Leuchtstoff beschichtete LED Chips getrennt wird.

Ein derartiges CSP LED Modul weist demnach individuell mit Leuchtstoff beschichtete CSP LED Chips auf, welche auf einem Substrat ohne zusätzliches Gehäuse angeordnet sind. Diese werden üblicherweise in geringen Abständen zueinander angeordnet, um ein größeres Lichtfeld zu erzeugen. Ein derartiges CSP LED Modul weist verbesserte thermische Eigenschaften gegenüber den oben beschriebenen konventionellen LED Modulen auf.

Die bekannten CSP LED Module weisen den Nachteil auf, dass zwischen den nahe zueinander gepackten LED-Chips mit Luft gefüllte Zwischenräume vorhanden sind, welche zu reflexiven Verlusten führen können und welche somit die Lichtausbeute des LED Moduls negativ beeinträchtigen.

Die DE 10 2013 109 890 A1 betrifft ein flexibles LED-Lichtquellenmodul mit einer flexiblen lichtdurchlässigen Deckplatte.

Die US 2006/0274524 A1 offenbart ein Lichtmodul mit einem Substrat, wenigstens einem auf dem Substrat befindlichen Licht emittierenden Element und einer Dichtungskappe, die das Licht emittierende Element abdeckt.

Die US 2014/0054616 A1 offenbart ein Verfahren und eine Vorrichtung zur Fertigung eines mit Leuchtstoff beschichteten LED-Dies.

Die US 2013/0056749 A1 offenbart ein Breitfeld ("Broad-Area")-Leuchtensystem.

Die US 2013/0187178 A1 offenbart Halbleiter-Dies, die in einem polymerischen Bindemittel eingebettet sind.

Die Aufgabe der vorliegenden Erfindung ist es daher ein verbessertes LED Modul mit CSP LEDs bereitzustellen, welches insbesondere eine verbesserte Lichtemission ermöglicht. Diese Aufgabe wird durch den unabhängigen

Anspruch gelöst. Die abhängigen Ansprüche stellen vorteilhafte Weiterbildungen des erfindungsgemäßen Gegenstands dar.

### Beschreibung der Erfindung

Die vorliegende Erfindung betrifft ein LED Modul aufweisend einen Träger und wenigstens zwei auf einer Oberfläche des Trägers angeordnete LED Bauelemente, wobei die LED Bauelemente jeweils individuell mit einer Vergussmasse umschlossene LED Chips bzw. LED Dies sind, und wobei die LED Bauelemente unter Ausbildung eines Zwischenraums angeordnet sind, und eine über den LED Bauelementen angeordnete transparente Abdeckung, welche die wenigstens zwei LED Bauelemente abdeckt und den Zwischenraum zwischen den LED Bauelementen wenigstens teilweise ausfüllt.

Durch die auf den LED Bauelementen angeordnete Abdeckung wird die Lichtausbeute des LED Moduls verbessert. Insbesondere werden Verluste durch Reflexion und/oder Brechung an der Oberfläche der LED Bauelemente minimiert bzw. verhindert.

Die LED Bauelemente sind sogenannte "Chip Scale Package" (CSP) LEDs. Dies bedeutet, dass die LED Chips bereits während der Chipherstellung individuell mit Vergussmasse umschlossen wurden und somit kein nachfolgender "Packaging" Schritt mehr notwendig ist. Die Vergussmasse kann aus transparentem Polymermaterial bestehen. Die Vergussmasse weist, erfindungsgemäß, darin eingebrachte Leuchtstoffpartikel auf.

Vorzugsweise weisen die CSP LEDs auf ihrer Rückseite p- und n-Kontakte auf, mit welchen diese direkt beispielsweise mit auf dem Träger angeordneten Leiterbahnen kontaktiert werden können. Die LED Bauelemente können beispielsweise mit einer "Pick-and-place" Maschine auf dem Träger angeordnet werden.

Die LED Chips bzw. die sogenannten "Dies" der LED Bauelemente sind vorzugsweise blaues oder ultraviolettes Licht emittierende LED Chips. Die Vergussmasse der LED Bauelemente ist erfindungsgemäß ine Silikonschicht oder , in Ausführungsformen die nicht zur Erfindung gehören, eine Epoxidharzschicht und weist darin eingebrachte Leuchtstoffpartikel auf.

Die Vergussmasse bildet somit eine den jeweiligen LED Chip umgebende Leuchtstoffschicht. Die Leuchtstoffpartikel in der Vergussmasse bzw. Leuchtstoffschicht der CSP LEDs sind vorzugsweise gelb und/oder grün emittierende Leuchtstoffpartikel. Diese wandeln das von dem LED Chip emittierte Primärlicht wenigstens teilweise in Licht einer höheren Wellenlänge um. Das resultierende Mischlicht der CSP LEDs ist vorzugsweise weißes Mischlicht. Die CSP LEDs können beispielsweise unterschiedliche Weißlichttöne und/oder weißes Licht mit unterschiedlichen Farbtemperaturen emittieren.

Die auf die LED Chips aufgetragene Vergussmasse bzw. Leuchtstoffschicht weist vorzugsweise eine Dicke t1 zwischen 100 und 300µm, mehr bevorzugt zwischen 150 und 250µm auf.

Die einzelnen LED Bauelemente weisen vorzugsweise eine Höhe h1 von zwischen 150 und 400µm, mehr bevorzugt zwischen 150 und 300µm auf.

Eine Seitenlänge der LED Bauelemente liegt vorzugsweise zwischen 100 und 400µm, mehr bevorzugt zwischen 150 und 300µm.

Die einzelnen LED Bauelemente sind in Draufsicht vorzugsweise quadratisch oder rechteckig geformt. Die sich in Draufsicht gegenüberliegenden äußeren Seitenflächen jedes LED Bauelements sind demnach vorzugsweise parallel zueinander angeordnet.

Die wenigstens zwei, vorzugsweise die Mehrzahl der LED Bauelemente des Moduls sind auf dem Träger vorzugsweise derart angeordnet, dass eine größtmögliche Dichte des resultierenden Lichtfelds erzielt wird. Die LED Bauelemente können insbesondere parallel zueinander angeordnet werden. Das resultierende Lichtfeld soll dabei eine vorzugsweise annähernd monolithische Struktur und/oder Oberfläche bilden. Die Mehrzahl der LED Bauelemente kann demnach dicht gepackt auf der Trägeroberfläche angeordnet werden, unter Ausbildung von mehreren zusammenhängenden Zwischenräumen zwischen sich jeweils gegenüberliegenden Seitenflächen der benachbarten LED Bauelemente. Die so entstehenden Zwischenräume sind vorzugsweise von der Abdeckung der LED Bauelemente wenigstens teilweise ausgefüllt.

Sich gegenüberliegenden Seitenflächen der jeweiligen benachbarten LED Bauelemente sind vorzugsweise im Wesentlichen parallel zueinander angeordnet. Der zwischen zwei LED Bauelementen vorhandene Zwischenraum ist demnach zwischen diesen sich gegenüberliegenden Seitenflächen angeordnet.

Ein Abstand d zwischen benachbarten LED Bauelementen bzw. zwischen zwei sich gegenüberliegenden Seitenflächen dieser LED Bauelemente beträgt vorzugsweise weniger als die Hälfte der kürzesten Seitenlänge der benachbarten LED Bauelemente.

Der Abstand d zwischen benachbarten LED Bauelementen bzw. zwischen zwei sich gegenüberliegenden Seitenflächen benachbarter LED Bauelemente liegt zwischen 50 und 250µm, bevorzugt zwischen 100 und 150µm.

Der Träger des LED Moduls ist vorzugsweise ein Trägersubstrat. Die Oberfläche des Trägers ist vorzugsweise eben. Der Träger ist eine Leiterplatte, auf welcher die wenigstens zwei LED Bauelemente aufgebracht sind. Insbesondere wenn der Träger als Leiterplatte ausgebildet ist, kann er aus elektrisch isolierendem Material bestehen. Das isolierende Material kann beispielsweise ein faserverstärkter Kunststoff oder auch Hartpapier, sein. Der Träger kann aus FR4, CEM1 oder CEM3 Material und/oder aus Metall wie beispielsweise Aluminium bestehen. Der Träger kann auch ein sogenannter

IMS Träger ("Insulated metal substrate") sein. Die Oberfläche des Trägers kann Leiterbahnen aufweisen, mit welchen die LED Bauelemente verbunden sind. Der Träger weist vorzugsweise eine quadratische oder rechteckige Form in Draufsicht auf.

Der Träger weist beispielsweise eine erhöhte Wärmeleitfähigkeit auf. Der Träger kann ausgeprägt sein, um als Wärmesenke zu fungieren. Die Materialstärke des Trägers liegt vorzugsweise zwischen 1 und 10mm, vorzugsweise zwischen 2 und 8mm. Auf der Rückseite des Trägers kann ein separater Kühlkörper oder eine Wärmesenke angeordnet sein. Dieser bzw. diese kann auch integral mit dem Träger ausgeprägt sein.

Die transparente Abdeckung des LED Moduls erstreckt sich vorzugsweise über die Gesamtheit aller LED Bauelemente des Moduls.

Die Abdeckung ist vorzugsweise direkt, d.h. ohne Zwischenschichten, angrenzend an die jeweiligen LED Bauelemente angeordnet. Die Abdeckung ist vorzugsweise derart angeordnet, dass diese direkt an den jeweiligen oberen Flächen der LED Bauelemente aufliegt. Die Abdeckung liegt vorzugsweise direkt an den jeweiligen oberen Kanten der LED Bauelemente an und umgibt diese. Dies bedeutet, dass auch wenigstens ein oberer Bereich der jeweiligen Seitenflächen der LED Bauelemente vorzugsweise von der Abdeckung bedeckt ist.

Die Abdeckung weist einen plattenförmigen Teilbereich auf. Des Weiteren weist die Abdeckung einen sich von dem im Wesentlichen plattenförmigen Teilbereich in den Zwischenraum zwischen benachbarte LED Bauelemente erstreckenden Vorsprung bzw. Zwischenraumfüller auf. Die Abdeckung weist vorzugsweise mehrere Vorsprünge auf, welche in Draufsicht das jeweilige LED Bauelement vollständig umgeben. Der bzw. die Vorsprünge sind vorzugsweise derart angeordnet, dass diese sich von dem plattenförmigen Teilbereich nach unten, d.h. in Richtung Trägeroberfläche, erstrecken.

Die Abdeckung ist vorzugsweise angeordnet, um die Oberseite des Lichtfelds aus mehreren LED Bauelementen komplett abzudecken bzw. zu überziehen.

Der plattenförmige Teilbereich der Abdeckung weist vorzugsweise eine Dicke t2 von zwischen 200 und 800µm, mehr bevorzugt zwischen 300 und 600µm auf. Der plattenförmige Teilbereich weist vorzugsweise eine homogene Dicke t2 auf.

In einer bevorzugten Ausführungsform füllt die transparente Abdeckung wenigstens einen oberen Teilbereich des Zwischenraums komplett aus. Dies bedeutet dass sich das Material der Abdeckung zwischen den sich gegenüberliegenden Seitenflächen benachbarter LED Bauelemente wenigstens in diesem oberen Teilbereich zusammenhängend von einer Seitenfläche zur gegenüberliegenden erstreckt. Die jeweiligen Seitenflächen der LED Bauelemente sind somit wenigstens in einem oberen Teilbereich von der Abdeckung bedeckt.

Der von der Abdeckung ausgefüllte obere Teilbereich entspricht vorzugsweise mindestens 35%, mehr bevorzugt mindestens 50% des Volumens des Zwischenraums. Die sich gegenüberliegenden Seitenflächen der benachbarten LED Bauelemente sind somit vorzugsweise wenigstens zu 35%, mehr bevorzugt zu 50% von der Abdeckung bedeckt, ausgehend von einer Oberkante der jeweiligen Seitenfläche.

Die Abdeckung kann den Zwischenraum auch vollständig ausfüllen. Dies bedeutet, dass sich der jeweilige in den Zwischenraum erstreckende Vorsprung der Abdeckung bis zur Oberfläche des Trägers als Zwischenraumfüller erstreckt. Hierbei sind die Seitenflächen der LED Bauelemente vorzugsweise vollständig durch die Abdeckung bzw. von den Zwischenraumfüllern der Abdeckung bedeckt.

Die Abdeckung ist vorzugsweise mit Hilfe eines Dispensverfahrens in einem noch teilweise flüssigen Zustand auf die Oberfläche der LED Bauelemente aufgetragen. In einem anschließenden Schritt kann die Abdeckung ausgehärtet werden. Die Abdeckung ist somit fest mit den LED Bauelementen verbunden. Hierdurch kommt es zu einem direkten und engen Kontakt ohne Zwischenräume insbesondere zwischen den oberen Flächen der LED Bauelemente und der Abdeckung. Die Abdeckung liegt vorzugsweise auch auf den bedeckten Seitenflächen der LED Bauelemente direkt an.

Die Abdeckung kann auch ein vorzugsweise vorgefertigtes Folienelement sein, welches auf die LED Bauelemente aufgetragen ist. Die Folie weist eine vorzugsweise homogene Dicke t2 von zwischen 200 und 800µm, mehr bevorzugt zwischen 300 und 600µm auf.

Die Abdeckung besteht aus einem Material, welches eine im Wesentlichen gleiche Brechzahl bzw. Brechungsindex wie die individuelle Vergussmasse bzw. Leuchtstoffschicht der LED Bauelemente aufweist.

Die Abdeckung besteht erfindungsgemäß aus Silikonmaterial oder Epoxidharz. Da die Brechzahl von Silikon im Wesentlichen gleich ist zu dem Brechungsindex der silikonbasierten Vergussmasse bzw. Leuchtstoffschicht auf den LED Bauelementen können Verluste durch Brechung und/oder Reflexion minimiert werden.

Die Abdeckung ist vorzugsweise aus einem zusammenhängenden Material ohne Zusatzmaterial geformt.

Die Abdeckung weist Leuchtstoffpartikel auf. Hierbei kann vor Aufbringen der Abdeckung das vom LED Modul emittierte Licht, insbesondere das Lichtspektrum, die Farbtemperatur und/oder die Helligkeit gemessen werden, und auf Basis der ermittelten Werte die Konzentration und/oder die Menge der in der Abdeckung eingebrachten Leuchtstoffpartikel vor deren Aufbringung angepasst werden. Hierdurch kann eine Anpassung bzw. Kompensation beispielsweise der Farbkoordinaten und/oder der Farbtemperatur des emittierten Mischlichts erfolgen.

Einzelne Bereiche der Abdeckung wie der im Wesentlichen plattenförmige Teilbereich und die Vorsprünge bzw. Zwischenraumfüller der Abdeckung können unterschiedliche Leuchtstoffpartikel und/oder unterschiedliche Leuchtstoffkonzentrationen aufweisen.

Alternativ oder zusätzlich kann die Abdeckung Reflexions- bzw. Streupartikel aufweisen. Hierdurch kann die Abdeckung als Diffusor verwendet werden.

In einem alternativen Ausführungsbeispiel weist die Abdeckung keine Reflexions- bzw. Streupartikel auf. Dies hat den Vorteil, dass eine mögliche Reflexion und/oder Streuung innerhalb der Abdeckung minimiert wird.

Das LED Modul weist vorzugsweise eine Vielzahl von auf dem Träger angeordneten LED Bauelementen auf. Der jeweilige Abstand d zwischen den LED Bauelementen und/oder zwischen zwei sich gegenüberliegenden Seitenflächen der LED Bauelemente ist dabei vorzugsweise im Wesentlichen konstant.

Als LED Bauelemente können zusätzlich oder alternativ auch sogenannte "Flip-Chip" (FC) LEDs angewendet werden. Die Flip-Chip LEDs haben eine ähnlichen Aufbau, wie dieser bei CSP LEDs beschrieben ist. Erfindungsgemäß können monochromatische und/oder leuchtstoffkonvertierte Flip-Chip LEDs eingesetzt werden.

### Kurzbeschreibung der Figuren

Nachfolgend werden Ausführungsbeispiele der Erfindung lediglich beispielhaft beschrieben und eine detaillierte Beschreibung der Figuren gegeben.
- Fig. 1a: und 1b zeigen ein LED Modul mit CSP LEDs gemäß dem Stand der Technik in Draufsicht und in seitlicher Schnittansicht.
- Fig. 2a: bis 2e zeigen bevorzugte Ausführungsformen eines erfindungsgemäßen LED Moduls in Draufsicht und in seitlicher Schnittansicht.

### Detaillierte Figurenbeschreibung

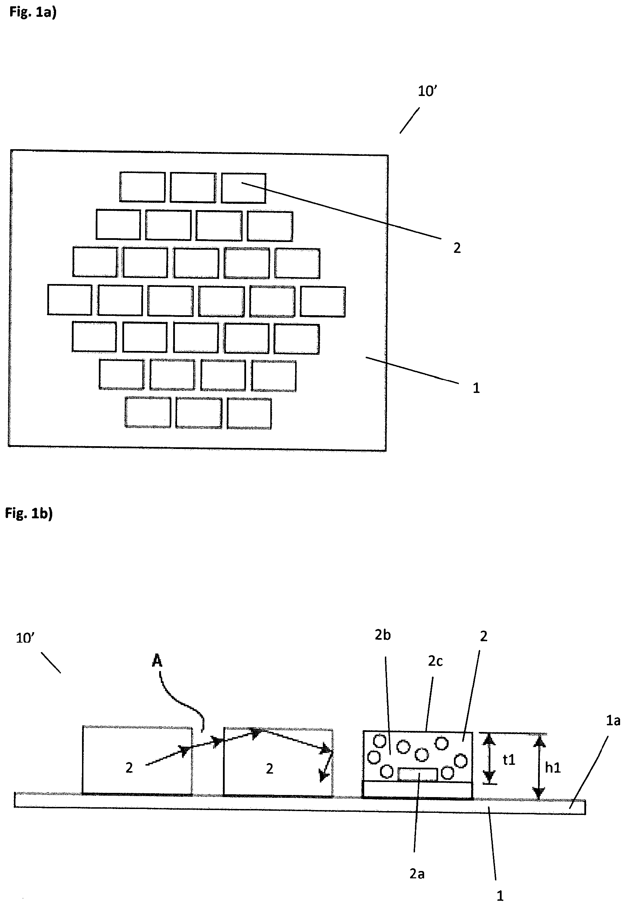

Fig. 1a und 1b zeigen ein LED Modul 10' gemäß dem Stand der Technik, wobei mehrere LED Bauelemente 2 auf einer Oberfläche 1a eines Trägers 1 angeordnet sind. Wie in Figur 1a gezeigt, können die LED Bauelemente 2 in einem zusammenhängenden Bereich des Trägers 1 angeordnet sein, um ein Lichtfeld zu bilden.

Die LED Bauelemente 2 sind sogenannte "Chip Scale Package" (CSP) LEDs, wobei eine CSP LED 2 in Fig. 1b schematisch in seitlicher Schnittansicht gezeigt ist. Die CSP LEDs weisen jeweils einen LED Chip bzw. sogenannten LED "Die" 2a auf, der mit einer Leuchtstoffschicht (oder mit einer Polymerschicht) bzw. Vergussmasse 2b umschlossen ist.

Bei der Lichtemission von den CSP LEDs 2 eines derartigen LED Moduls 10' kommt es zu Verlusten durch Reflexion und/oder Brechung, welche die Lichtausbeute des LED Moduls verringern. Dies ist durch die Pfeile A in Fig. 1b schematisch gezeigt. Insbesondere kommt es an der Grenzschicht zwischen der Vergussmasse bzw. Leuchtstoffschicht 2b der jeweiligen CSP LED 2 und der Umgebungsluft zu einer Brechung des Lichtstrahls A. Dieser wird dann hin zu einer benachbarten CSP LED 2 abgelenkt, wobei an der Grenzschicht zwischen Umgebungsluft und der Vergussmasse bzw. Leuchtstoffschicht 2b dieses benachbarten CSP LED 2 wieder eine Brechung und/oder Reflexion stattfindet. Durch die hierdurch erfolgte Ablenkung kann der Lichtstrahl A an einer oberen Fläche 2c dieser CSP LED 2 wieder nach Innen reflektiert werden.

Im Gegensatz zum oben beschriebenen LED Modul 10' weist das erfindungsgemäße LED Modul 10 eine Abdeckung oder eine Schicht 3 auf, welche derartige Verluste durch Brechung und/oder Reflexion minimiert.

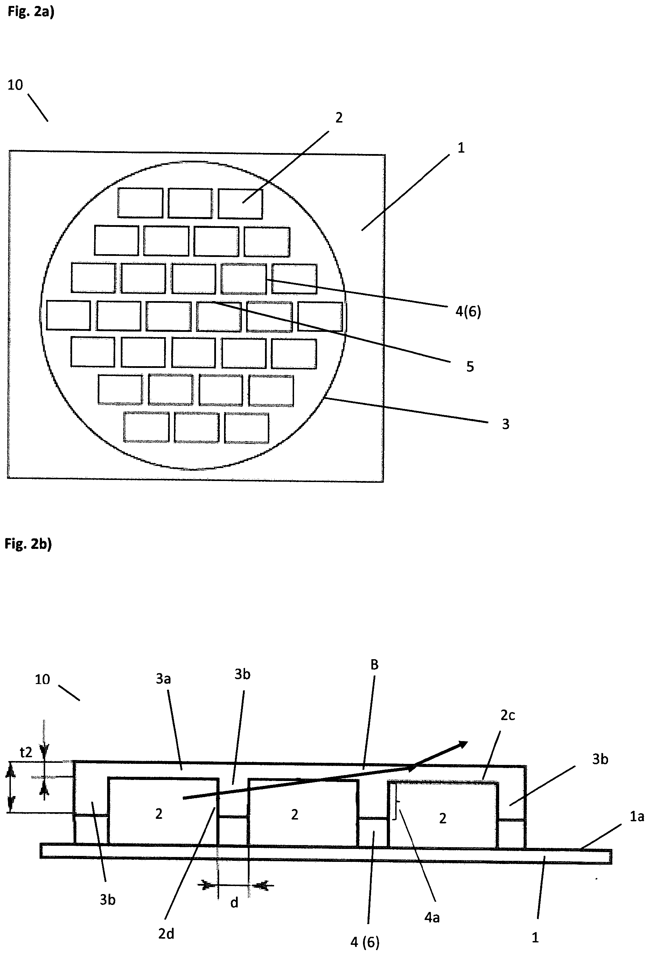

Wie in den Fig. 2a bis 2e dargestellt, weist das erfindungsgemäße LED Modul 10 einen Träger 1 und wenigstens zwei auf einer Oberfläche 1a des Trägers angeordnete LED Bauelemente 2 auf. Bei den LED Bauelementen 2 handelt es sich um die oben beschriebenen CSP LEDs.

Beispielsweise ist der Träger 1 als Leiterplatte ausgebildet und besteht aus elektrisch isolierendem Material, beispielsweise FR4, CEM3 oder CEM1. Der Träger 1 kann bspw. durch eine Metallkernplatine (MC PCB) oder durch eine Mehrschichtplatine, die eine Aluminium- oder Kupferschicht (oder Platte) aufweist, realisiert sein. Die LED Bauelemente 2 können direkt auf die Metallschicht bzw. Metallplatte der Mehrschichtplatine aufgebracht werden.

Die CSP LEDs 10 gemäß der vorliegenden Erfindung weisen vorzugsweise eine transparente Vergussmasse oder Leuchtstoffschicht 2b auf, welche aus Silikonmaterial besteht. Die Dicke t1 (siehe Fig. 1b) der jeweiligen Leuchtstoffschicht 2b liegt vorzugsweise zwischen 100 und 300µm, mehr bevorzugt zwischen 150 und 250µm.

Die einzelnen CSP LEDs 2 weisen vorzugsweise eine Höhe h1 (siehe Fig. 1b) von zwischen 150 und 400µm, mehr bevorzugt zwischen 150 und 300µm auf.

Die CSP LEDs 2 weisen eine in Draufsicht vorzugsweise quadratische oder rechteckige Form auf. Vorzugsweise sind mehrere CSP LEDs 2 in einem Bereich des Trägers 1 angeordnet, um ein zusammenhängendes Lichtfeld 5 zu bilden. Zwischen den CSP LEDs 2 ist ein Zwischenraum 4 vorhanden. Dieser ist vorzugsweise zwischen zwei sich gegenüberliegenden Grenz- bzw. Seitenflächen 2d der CSP LEDs 2 angeordnet.

Die CSP LEDs 2 sind im Lichtfeld 5 vorzugsweise parallel zueinander angeordnet. Hierbei sind sich gegenüberliegende Seitenflächen 2d der einzelnen CSP LEDs 2 jeweils im Wesentlichen parallel zueinander angeordnet.

Ein seitlicher Abstand d zwischen zwei CSP LEDs 2 bzw. sich gegenüberliegenden Seitenflächen 2d der CSP LEDs beträgt vorzugsweise weniger als die Hälfte der kürzesten Seitenlänge der benachbarten CSP LEDs. Der Abstand d kann zwischen 0.1mm bis 2.5mm, bevorzugt zwischen 0.1 bis 2.0mm betragen. In einer erfindungsgemäßen

Ausführungsform beträgt der Abstand zwischen 50 und 250µm, bevorzugt zwischen 100 und 150µm.

Das LED Modul 10 weist ferner eine über den CSP LEDs angeordnete transparente Abdeckung oder Schicht 3 auf, welche die CSP LEDs 2 des Moduls 10 abdeckt und den jeweiligen Zwischenraum 4 zwischen den CSP LEDs 2 wenigstens teilweise ausfüllt. Die Abdeckung ist vorzugsweise mittels einem Dispensverfahren aufgetragen. Wie in Fig. 2b gezeigt liegt die Abdeckung 3 vorzugsweise direkt auf der Oberfläche der CSP LEDs 2 auf, ohne Zwischenschichten.

Die Abdeckung 3 besteht vorzugsweise im Wesentlichen aus einem Material, welches einen im Wesentlichen gleichen oder relativ ähnlichen Brechungsindex bzw. Brechzahl wie das Material der Vergussmasse oder der Leuchtstoffschicht 2b der CSP LEDs aufweist. Die Abdeckung 3 besteht somit vorzugsweise aus einem Material, welches eine im Wesentlichen gleiche Brechzahl bzw. Brechungsindex wie die individuelle Vergussmasse 2b der LED Chips 2a aufweist. Hierdurch wird erzielt, dass die Verluste durch Brechung und/oder Reflexion des LED Moduls 10 minimiert werden. Wie in Fig. 2b dargestellt, kann ein Lichtstrahl B dann die Grenzschichten zwischen der Vergussmasse oder Leuchtstoffschicht 2b der CSP LEDs 2 und der Abdeckung 3 ohne Brechung und/oder Reflexion passieren. Auch wird eine erneute Einkopplung des Lichtstrahls B in eine benachbarte CSP LED 2 vorzugsweise verhindert.

Die Abdeckung 3 besteht aus Silikonmaterial oder Epoxidharz und weist vorzugsweise keine zusätzlichen Materialien oder Partikel auf. Die Abdeckung 3 weist jedoch auch Leuchtstoffpartikel auf und kann Reflexionspartikel bzw. Streupartikel aufweisen.

Wie in Figuren 2b-2d gezeigt weist die Abdeckung 3 vorzugsweise einen im Wesentlichen platten- bzw. scheibenförmigen Teilbereich 3a und wenigstens einen sich von diesem in den Zwischenraum 4 erstreckenden Vorsprung 3b auf. Der plattenförmige Teilbereich 3a ist in Draufsicht vorzugsweise kreisförmig (siehe Fig. 2a).

Der plattenförmige Teilbereich 3a der Abdeckung 3 weist eine vorzugsweise homogene Dicke t2 von zwischen 200 und 800µm, mehr bevorzugt zwischen 300 und 600µm auf.

Die Abdeckung 3 weist vorzugsweise mehrere Vorsprünge 3b auf, welche in Draufsicht die jeweilige CSP LED 2 vollständig umgeben.

Der wenigstens einen Vorsprung 3b erstreckt von einer Oberfläche der Abdeckung zu einer Tiefe t3, welche zwischen 300 und 1000µm, mehr bevorzugt zwischen 400 und 700µm liegt.

Der bzw. die Vorsprünge 3b decken die Seitenflächen 2d der CSP LEDs 2 wenigstens teilweise ab. Insbesondere wird wenigstens ein oberer Teilbereich der jeweiligen Seitenflächen 2d abgedeckt. Die Vorsprünge 3b können die Seitenflächen 2d der CSP LEDs 2 ganz bedecken.

Der wenigstens eine Vorsprung 3b erstreckt sich vorzugsweise entlang einer Seitenwand 2d der jeweiligen CSP LED von einer oberen Fläche 2c der CSP LED bis zu einer vordefinierten Tiefe, welche der Differenz aus dem Parametern t3 und t2, wie oben beschrieben, entspricht.

Die Abdeckung 3 füllt vorzugsweise wenigstens einen oberen Teilbereich 4a des jeweiligen Zwischenraums 4 komplett aus. Dieser obere Teilbereich 4a entspricht vorzugsweise mindestens 35% vorzugsweise mindestens 50% des Volumens des jeweiligen Zwischenraums 4.

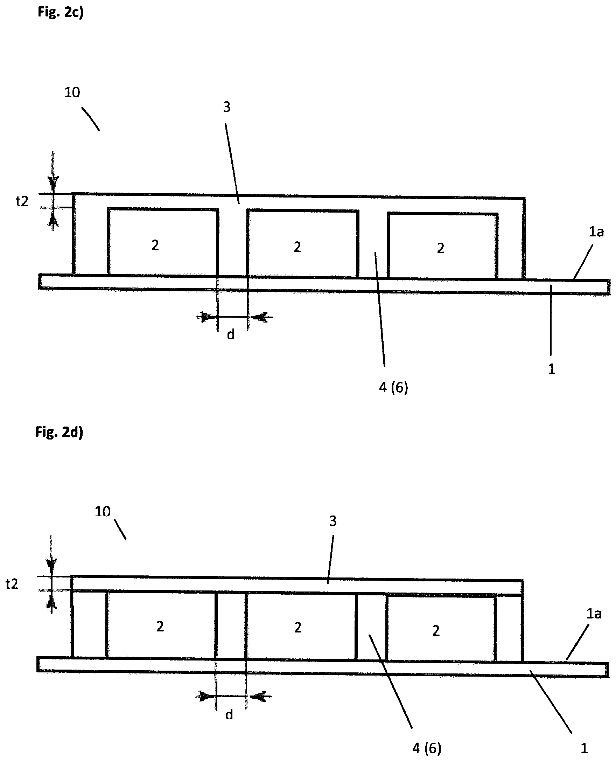

Der wenigstens eine Vorsprung 3b der Abdeckung 3 kann somit einen Zwischenraumfüller 6 bilden, wie in Figuren 2b, 2c und 2d gezeigt ist. Der Zwischenraumfüller 6 bzw. die Abdeckung 3 kann bündig mit dem CSP LED 2 abschließen.

Der Zwischenraumfüller 6 ist vorzugsweise integral mit der plattenförmigen Teilbereich 3a der Abdeckung 3 ausgeprägt, wie in Figuren 2b und 2c gezeigt. Der Zwischenraumfüller 6 kann aber auch als zusätzliches Element zum plattenförmigen Teilbereich 3a ausgeprägt sein, wie in Figur 2d dargestellt. Hierbei liegt der Zwischenraumfüller 6 vorzugsweise bündig an die plattenförmige Abdeckung 3 an.

Der Zwischenraumfüller 6 kann Streupartikel und/oder Leuchtstoffpartikel (oder eine Leuchtstoffpartikelmischung) enthalten. Die gleichen oder unterschiedlichen Streu- und Leuchtstoffpartikel können in der Schicht bzw. Abdeckung 3 und in dem Zwischenraumfüller 6 eingesetzt werden. Es ist denkbar, dass die Schicht 3 und der Zwischenraumfüller 6 die Streu- und/oder Leuchtstoffpartikel in unterschiedlichen Konzentrationen aufweisen. Durch Einsetzung unterschiedlicher Leuchtstoffe bzw. Leuchtstoffmischungen oder unterschiedlicher Leuchtstoffkonzentrationen in der Schichten 3 und dem bzw. den Zwischenraumfüllern 6 kann weißes Licht mit unterschiedlichen Farbtemperaturen generiert werden.

Die Abdeckung 3 bzw. der Zwischenraumfüller 6 kann den jeweiligen Zwischenraum 4 vollständig ausfüllen, wie in Figuren 2c und 2d gezeigt.

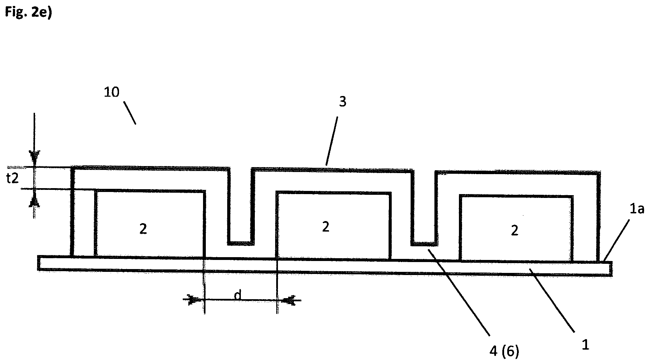

Figur 2e zeigt eine weitere bevorzugte Ausführungsform des erfindungsgemäßen LED Moduls. Hierbei ist die Abdeckung 3 in Form eines Folienelements realisiert, welche auf die CSP LEDs 2 aufgetragen ist. Die Abdeckung bzw. Folie 3 füllt den Zwischenraum 4 zwischen zwei benachbarten CSP LEDs 2 vorzugsweise nicht komplett aus. Die Seitenwände 2d der benachbarten CSP LEDs sind vorzugsweise vollständig von der Folie 2 bedeckt. Die Folie 3 deckt somit vorzugsweise die Oberflächen 2c und Seitenwände 2d der CSP LEDs 2 vollständig ab.

Die Folie weist vorzugsweise eine konstante Schichtdicke t2 auf. Diese kann zwischen 200 und 800µm, mehr bevorzugt zwischen 300 und 600µm, liegen.

Das durch die CSP LEDs 2 geformte Lichtfeld 5 ist vorzugsweise mittig auf dem Träger 1 angeordnet. Die CSP LEDs 2 sind dabei vorzugsweise derart angeordnet, dass die zwischen den einzelnen CSP LEDs 2 vorhandenen Zwischenräume 4 minimiert werden. Die Zwischenräume 4 zwischen den jeweiligen CSP LEDs 2 weisen vorzugsweise eine konstante Breite d auf. Die konstante Breite d kann zwischen 0.1mm und 2.5mm, bevorzugt zwischen 0.1 und 2.0mm betragen. In der erfindungsgemäßen

Ausführungsform beträgt der Abstand zwischen 50 und 250µm, bevorzugt zwischen 100 und 150µm.

## Patentansprüche

1. LED Modul (10) aufweisend:
- einen Träger (1) und wenigstens zwei auf einer Oberfläche (1a) des Trägers angeordnete LED Bauelemente (2),
wobei die LED Bauelemente (2) jeweils individuell mit einer Vergussmasse (2b) umschlossene LED Chips (2a) sind,
wobei die LED Bauelemente (2) unter Ausbildung eines Zwischenraums (4) angeordnet sind, und
- eine über den LED Bauelementen (2) angeordnete transparente Abdeckung (3), welche die wenigstens zwei LED Bauelemente (2) abdeckt und den Zwischenraum (4) zwischen den LED Bauelementen (2) wenigstens teilweise ausfüllt,
wobei der Träger (1) eine Leiterplatte ist, und
wobei die LED Bauelemente (2) "Chip Scale Package" (CSP) LEDs sind,
wobei die auf den individuellen LED Chips (2a) aufgetragene Vergussmasse (2b) aus Silikonmaterial besteht,
wobei die Abdeckung (3) aus Silikonmaterial oder Epoxidharz besteht,
wobei ein seitlicher Abstand (d) zwischen zwei LED Bauelementen (2) zwischen 50 und 250µm liegt,
wobei die transparente Abdeckung (3) einen plattenförmigen Teilbereich (3a) und wenigstens einen sich von diesem in den Zwischenraum (4) erstreckenden Vorsprung (3b) aufweist,
wobei die Vergussmasse (2b) darin eingebrachte Leuchtstoffpartikel aufweist und somit eine den LED Chip (2a) umgebende Leuchtstoffschicht bildet,
wobei die Leuchtstoffpartikel ausgebildet sind, ein von den LED Chips (2a) emittiertes Licht wenigstens teilweise in Licht einer höheren Wellenlänge umzuwandeln, so dass ein Mischlicht entsteht, und wobei die Abdeckung (3) weitere Leuchtstoffpartikel aufweist, um eine Anpassung bzw. Kompensation von Farbkoordinaten und/oder einer Farbtemperatur des Mischlichts zu bewirken.

2. LED Modul nach Anspruch 1,
wobei die auf den individuellen LED Chips (2a) aufgetragene Vergussmasse (2b) eine Dicke (t1) zwischen 100 und 300µm, bevorzugt zwischen 150 und 250µm aufweist.

3. LED Modul nach einem der vorhergehenden Ansprüche, wobei der Zwischenraum (4) zwischen zwei sich vorzugsweise parallel gegenüberliegenden Seitenflächen benachbarter LED Bauelemente (2) angeordnet ist.

4. LED Modul nach einem der vorhergehenden Ansprüche,
wobei ein seitlicher Abstand (d) zwischen zwei benachbarten LED Bauelementen (2) weniger als die Hälfte der kürzesten Seitenlänge der benachbarten LED Bauelemente (2) beträgt, und/oder.
wobei ein seitlicher Abstand (d) zwischen zwei LED Bauelementen (2) zwischen 100 und 150µm liegt.

5. LED Modul nach einem der vorhergehenden Ansprüche, wobei die transparente Abdeckung (3) mehrere Vorsprünge (3b) aufweist, welche in Draufsicht das jeweilige LED Bauelement (2) vollständig umgeben.

6. LED Modul nach Anspruch 5,
wobei der plattenförmige Teilbereich (3a) der Abdeckung (3) eine vorzugsweise homogene Dicke (t2) von zwischen 200 und 800µm, vorzugsweise zwischen 300 und 600µm aufweist.

7. LED Modul nach einem der vorhergehenden Ansprüche, wobei die transparente Abdeckung (3) wenigstens einen oberen Teilbereich (4a) des Zwischenraums (4) komplett ausfüllt.

8. LED Modul nach einem der vorhergehenden Ansprüche, wobei der Zwischenraum (4) mit einem Zwischenraumfüller (6) bündig mit den LED Chips (2) aufgefüllt ist.

9. LED Modul nach einem der vorhergehenden Ansprüche, wobei die transparente Abdeckung (3) wenigstens einen oberen Teilbereich der Seitenwände der LED Bauelemente (2) bedeckt.

10. LED Modul nach einem der vorhergehenden Ansprüche, wobei die Abdeckung (3) den Zwischenraum (4) und/oder die Seitenwände der LED Bauelemente (2) vollständig ausfüllt bzw. bedeckt.

11. LED Modul nach einem der vorhergehenden Ansprüche, wobei die Abdeckung (3) und/oder ein Zwischenraumfüller (6) mittels einem Dispensverfahren auf die LED Bauelemente (2) aufgetragen ist, oder wobei die Abdeckung (3) ein vorzugsweise vorgefertigtes Folienelement ist.

12. LED Modul nach einem der vorhergehenden Ansprüche, wobei die Abdeckung (3) Streupartikel aufweist.

13. LED Modul nach einem der vorhergehenden Ansprüche, wobei das LED Modul (10) eine Vielzahl von LED Bauelementen (2) aufweist,
wobei vorzugsweise der jeweilige seitliche Abstand (d) zwischen zwei benachbarten LED Bauelementen (2) im Wesentlichen konstant ist.

## Claims

1. An LED module (10) comprising:
- a substrate (1) and at least two LED components (2) arranged on a surface (1a) of the substrate,
wherein the LED components (2) are each LED chips (2a) individually enclosed with a casting compound (2b), wherein the LED components (2) are arranged to form an interstice (4), and
- a transparent cover (3) arranged over the LED components (2), which covers the at least two LED components (2) and at least partially fills in the interstice (4) between the LED components (2),
wherein the substrate (1) is a printed circuit board, and
wherein the LED components (2) are "chip scale package" (CSP) LEDs,
wherein the casting compound (2b) applied to the individual LED chips (2a) is made of silicone material,
wherein the cover (3) is made of silicone material or epoxy resin,
wherein a lateral distance (d) between two LED components (2) is between 50 and 250 µm,
wherein the transparent cover (3) comprises a plate-shaped sub-area (3a) and at least one projection (3b) extending therefrom into the interstice (4),
wherein the casting compound (2b) comprises fluorescent particles introduced therein and thus forms a fluorescent layer surrounding the LED chip (2a),
wherein the fluorescent particles are configured in order to convert a light emitted by the LED chips (2a) at least partially into light of a higher wavelength so that a mixed light is generated, and wherein the cover (3) comprises further fluorescent particles in order to achieve an adjustment or compensation of color coordinates and/or a color temperature of the mixed light.

2. The LED module according to Claim 1,
wherein the casting compound (2b) applied on the individual LED chips (2a) has a thickness (t1) of between 100 and 300 µm, preferably between 150 and 250 µm.

3. The LED module according to any of the preceding claims, wherein the interstice (4) is arranged between two adjacent LED components (2) that are preferably opposite in parallel.

4. The LED module according to any of the preceding claims,
wherein a lateral distance (d) between two adjacent LED components (2) is less than half of the shortest side length of the adjacent LED components (2), and/or
wherein a lateral distance (d) between two LED components (2) is between 100 and 150 µm.

5. The LED module according to any of the preceding claims, wherein the transparent cover (3) comprises a plurality of projections (3b) which completely surround the respective LED component (2) in a plan view.

6. The LED module according to Claim 5,
wherein the plate-shaped sub-area (3a) of the cover (3) has a preferably homogeneous thickness (t2) of between 200 and 800 µm, preferably between 300 and 600 µm.

7. The LED module according to any of the preceding claims, wherein the transparent cover (3) completely fills in at least one upper sub-area (4a) of the interstice (4).

8. The LED module according to any of the preceding claims, wherein the interstice (4) is filled in flush with the LED chips (2) with an interstice filler (6).

9. The LED module according to any of the preceding claims, wherein the transparent cover (3) covers at least one upper sub-area of the side walls of the LED components (2).

10. The LED module according to any of the preceding claims, wherein the cover (3) completely fills in or covers the interstice (4) and/or the side walls of the LED components (2) .

11. The LED module according to any of the preceding claims, wherein the cover (3) and/or an interstice filler (6) is applied to the LED components (2) by means of a dispensing method, or wherein the cover (3) is a preferably pre-assembled film element.

12. The LED module according to any of the preceding claims, wherein the cover (3) comprises scattering particles.

13. The LED module according to any of the preceding claims, wherein the LED module (10) comprises a plurality of LED components (2),
wherein preferably the respective lateral distance (d) between two adjacent LED components (2) is substantially constant.

## Revendications

1. Module LED (10) présentant :
- un support (1) et au moins deux composants LED (2) disposés sur une surface (1a) dudit support,
lesdits composants LED (2) consistant respectivement en des puces LED (2a) individuellement entourées d'un matériau d'enrobage (2b),
l'agencement desdits composants LED (2) créant un espace intermédiaire (4), et
- une protection transparente (3) agencée au-dessus des composants LED (2), couvrant au moins les deux composants LED (2) et comblant au moins une partie de l'espace intermédiaire (4) entre lesdits composants LED (2),
ledit support (1) étant une carte imprimée, et
lesdits composants LED (2) sont des LED de type boîtier-puce (CSP, Chip Scale Package),
ledit matériau d'enrobage (2b) appliqué sur les puces LED (2a) individuelles se composant d'un matériau à base de silicone, ladite protection (3) se composant de matériau à base de silicone ou se composant de résine époxyde,
une distance latérale (d) séparant deux composants LED (2) étant comprise entre 50 et 250 µm,
ladite protection transparente (3) présentant une zone partielle (3a) en forme de plaque et au moins une partie (3b) faisant saillie à partir de celle-ci et pénétrant dans l'espace intermédiaire (4),
ledit matériau d'enrobage (2b) présentant des particules luminophores qui y sont intégrées et constituant ainsi une couche luminophore entourant la puce LED (2a),
lesdites particules luminophores étant conçues pour convertir au moins partiellement la lumière émise par les puces LED (2a) en une lumière de plus grande longueur d'onde de façon à créer une lumière mixte, ladite protection (3) présentant d'autres particules luminophores visant à réaliser une adaptation ou une compensation des coordonnées de couleur et/ou de la température de couleur de la lumière mixte.

2. Module LED selon la revendication 1,
dans lequel le matériau d'enrobage (2a) appliqué sur les puces LED (2b) individuelles présente une épaisseur (t1) comprise entre 100 et 300 µm, de préférence entre 150 et 250 µm.

3. Module LED selon l'une des revendications précédentes, dans lequel l'espace intermédiaire (4) est agencé entre deux surfaces latérales opposées, de préférence en parallèle, de composants LED (2) adjacents.

4. Module LED selon l'une des revendications précédentes,
dans lequel la distance latérale (d) séparant deux composants DEL (2) adjacents est inférieure à la moitié de la longueur latérale la plus courte desdits composants LED (2) adjacents, et/ou
dans lequel la distance latérale (d) séparant deux composants DEL (2) adjacents est comprise 100 et 150 µm.

5. Module LED selon l'une des revendications précédentes, dans lequel la protection transparente (3) présente plusieurs parties faisant saillie (3b) qui entourent entièrement le composant LED (2) respectif, vu de dessus.

6. Module LED selon la revendication 5,
dans lequel la zone partielle (3a) en forme de plaque de la protection (3) présente une épaisseur (t2) de préférence homogène comprise entre 200 et 800 µm, de préférence entre 300 et 600 µm.

7. Module LED selon l'une des revendications précédentes, dans lequel la protection transparente (3) comble complètement au moins une zone partielle supérieure (4a) de l'espace intermédiaire (4).

8. Module LED selon l'une des revendications précédentes, dans lequel l'espace intermédiaire (4) est rempli par un organe de remplissage d'espace (6) en affleurement avec les puces LED (2) .

9. Module LED selon l'une des revendications précédentes, dans lequel la protection transparente (3) recouvre au moins une zone partielle supérieure des parois latérales des composants LED (2).

10. Module LED selon l'une des revendications précédentes, dans lequel la protection (3) comble voire couvre entièrement l'espace intermédiaire (4) et/ou les parois latérales des composants LED (2).

11. Module LED selon l'une des revendications précédentes, dans lequel la protection (3) et/ou un organe de remplissage d'espace (6) sont appliqués sur les composants LED (2) selon un processus de distribution, ou dans lequel la protection (3) consiste de préférence en un élément pelliculaire préfabriqué.

12. Module LED selon l'une des revendications précédentes, dans lequel la protection (3) présente des particules diffusant la lumière.

13. Module LED selon l'une des revendications précédentes, dans lequel le module LED (10) présente une pluralité de composants LED (2),
la distance latérale (d) respective séparant deux composants LED (2) adjacents étant de préférence sensiblement constante.
